# EUROPEAN PATENT APPLICATION

(11) **EP 1 852 972 A1**
(43) Date of publication of application: **07.11.2007**
(21) Application number: 06009071.9
(22) Date of filing: 02.05.2006
(51) Int. Cl.: H03F 3/343

(54) **Single-ended to differential buffer amplifier**

(71) Applicant: Infineon Technologies AG, 81669 München (DE)
(72) Inventor: Grewing, Christian, 19146 Sollentua (SE); Einerman, Wenche, 18135 Lidingö (SE)
(74) Representative: Schoppe, Fritz

(57) **Abstract**

The invention relates to an input buffer amplifier 1 suitable for a system on chip device. The input buffer amplifier 1 comprises a single ended input and a differential output. The input terminal is connected to a first differential stage 2 comprising two transistors T₁, T₂ and to a second differential stage 3 comprising two transistors T₃, T₄. The first and second differential stages 2, 3 are further connected to a first and second load, for example current mirrors 10, 20, being connected so as to provide a differential output at the output terminals OUT_{P}, OUT_{N}.

## Description

### Field of the invention

The invention relates to the field of amplifiers, and in particular to an input buffer amplifier as defined in claim 1.

### Background of the invention

System-on-a-chip (SoC) is an integration of all components of an electronic system into a single chip. The SoC may contain digital, analog, mixed-signal and radio frequency functions, all on the same chip. That is, a SoC device may comprise a number of subsystems performing very different functions. SoC designs replace multi-chip systems and usually consume less power and have a lower cost and higher reliability than the multi-chip systems.

The interface of a SoC generally consists of configurable logic blocks, configurable I/O blocks, and programmable interconnect. Clock circuitry drives clock signals to each logic block and additional logic resources such as memory may be available. Clock systems are needed for synchronizing the I/O signals of the SoC as well as for the functionality of the chip. A configurable I/O block may be used for bringing signals onto a chip and send them forward. It consists of an input buffer, an output buffer, and two flip-flops. One flip-flop is used to clock the output signal to shorten the clock-to-output delay for signals going off chip, while the other is used to register chip input, decreasing the device hold time requirement.

The clock inputs of a SoC device are very sensitive to coupling capacitances. Coupling causes jitter and will be seen as phase noise and similar disturbances. The input buffer of the clock device of a SoC therefore needs to have a sufficient gain in order to avoid such phase noise and disturbances caused by coupling in the SoC.

Further, in many platforms the clock signals have a sine wave form with a DC (direct current) level that is not standardized and will vary for different standards. The input buffer of the clock device therefore has to be insensitive to the DC level of the input signal.

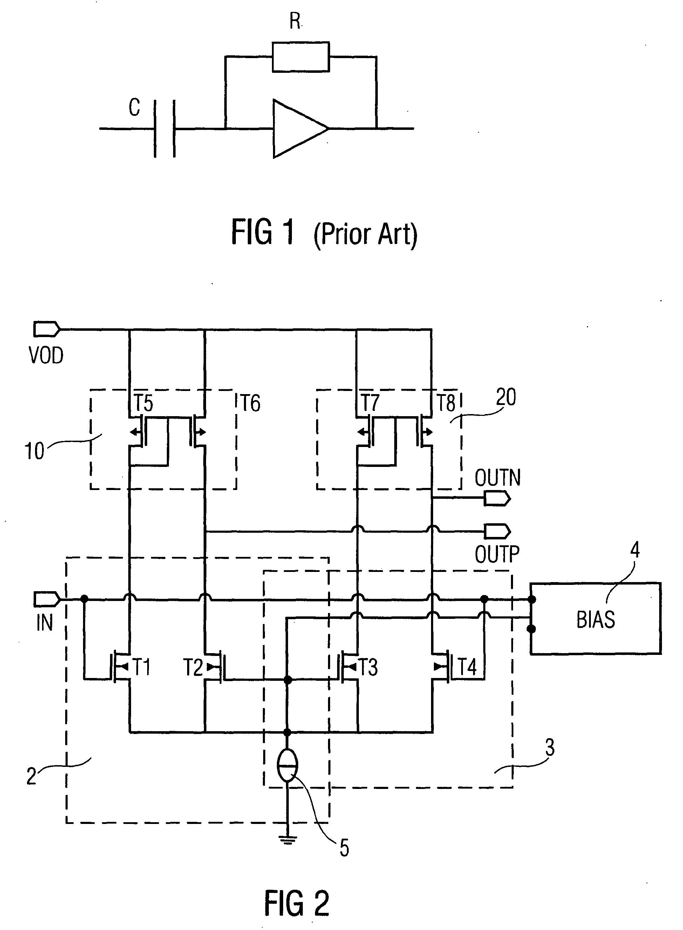

In accordance with the state of the art this problem can be overcome by using single-ended amplifiers with a highpass filtering (AC-coupling) at the input of the buffer. That is, a circuit is included for removing the static components from the signal input to the amplifier, leaving only the components of the signal that varies with time. Such prior art solution is illustrated schematically in figure 1.

However, this solution entails a number of drawbacks. In the start up and power down scenarios problems occur due to the limited lower bandwidth of the input buffer. For maximum gain of the input buffer the DC point of the input is often regulated, which limits the input frequency range with respect to possible instabilities of the feedback loop.

From the above it is clear that it would be desirable to improve the performance of input buffers of an electrical circuitry, such as a SoC-device.

### Summary of the invention

It is an object of the invention to provide an improved input buffer amplifier for an electrical circuit, such as a system-on-chip device. In particular it is an object of the invention to provide an input buffer amplifier that is less sensitive to on-chip couplings.

It is another object of the invention to provide an improved input buffer amplifier for an electrical circuit, for example a system-on-chip device, that is insensitive to varying DC levels of an input signal.

It is yet another object of the invention to provide such input buffer amplifier without lowering the gain of the input buffer amplifier. That is, an input buffer amplifier still providing as high gain as possible, thereby reducing the effects of phase noise and other disturbances.

It is still another object of the invention to provide an input buffer amplifier providing a proper voltage immediately upon power up, thus overcoming or at least alleviating the problems at start up and power down of the prior art solution.

These objects, among others, are achieved by an input buffer amplifier as claimed in claim 1 and by an electrical circuit device comprising such input buffer amplifier, as claimed in claim 10. By means of the invention a high gain amplifier is provided, having a single ended input and a differential output.

In accordance with the invention, an input buffer amplifier is provided, suitable for an electrical circuit such as a system on chip device. The input buffer amplifier comprises a single ended input and a differential output. The differential output is accomplished by having the input terminal connected to a first differential stage comprising two transistors and to a second differential stage also comprising two transistors. The first and second differential stages are further connected to a first and second load connected so as to provide a differential output at the output terminals. By means of the invention an improved input device suitable for use in, for example a system-on-chip device, is provided. Other electrical circuits besides SoC also benefit from the invention. The inventive input device is not sensitive to DC variations of an input signal. Further, by means of the invention the problems related to start up and power down of the device, as present in prior art solutions, are overcome. That is, the output signal reproduced by the input buffer amplifier match the input signal shape almost immediately.

In an embodiment of the invention, the first and second load a first and second current mirror being connected so as to provide the differential output at the output terminals. This provides a high gain and is a preferred embodiment. In alternative embodiments the load is implemented as first and second folded cascade, and in yet another embodiment as resistive loads.

Further characteristics of the invention and advantages thereof will be evident from the detailed description of a preferred embodiment of the present invention given hereinafter and the accompanying figures, which are only given by way of illustration, and thus are not limitative of the present invention.

### Brief description of the drawings

Figure 1 illustrates schematically a prior art solution.
Figure 2 illustrates a first embodiment of the present invention.
Figure 3 illustrates a second embodiment of the present invention.

### Detailed description of preferred embodiments

An input buffer amplifier, or in the following denoted an input buffer or simply a buffer, is an amplifier that provides buffering between one circuit and another. Typically a buffer amplifier is used to transfer a voltage from a first circuit, having a high impedance level, to a second circuit with a lower impedance level. The interposed buffer amplifier prevents the second circuit from loading the first circuit unacceptably and interfering with its desired operation.

Figure 2 illustrates a first embodiment of the invention. In accordance with the invention, the input buffer amplifier circuit 1 is implemented by means of two differential stages. The input buffer 1 comprises a single-ended input terminal In and differential output terminals OUT_{P} and OUT_{N}. In the figure a first differential stage is indicated by reference numeral 2, and a second differential stage is indicated by reference numeral 3. A differential output is less sensitive to on-chip couplings, which characteristic is utilized in the present invention for providing a high gain and low current buffer. In the figure, the first differential stage 2 and the second differential stage 3 comprise transistors T₁, T₂, and T₃, T₄, respectively.

The input signal is input to the first differential stage 2 and to the second differential stage 3. More specifically, the input signal is input to the gate of a first transistor T₁ of the first differential stage 2 and to the gate of a fourth transistor T₄ or the second differential stage 3. A bias voltage V_{ref} is provided from a biasing circuit 2, which voltage determines the threshold voltage when the current decreases. The transistors should be biased for linear operation, i.e. the bias circuit 4 could be chosen in a conventional manner. However, it is realized that any other load could be chosen.

In the first differential stage 2, the gate of the first transistor T₁ is connected to the input terminal In. The sources of the transistors T₁, T₂ are connected to a current source 5 and the drains of transistors T₁, T₂ are connected to the sources of transistors T₅, T₆ of a first current mirror (described later).

The second differential stage 3 is equivalent to the first differential stage. Hence, the gate of the fourth transistor T₄ is connected to the input terminal In, the sources of the transistors T₃, T₄ are connected to the current source 5 and the drains of transistors T₃, T₄ are connected to the sources of transistors T₇, T₈ of a second current mirror (described later).

The gates of transistors T₂, T₃ of the first and second differential stages 2, 3 are interconnected.

As is well known, a current mirror is a circuit designed to copy a current flowing through one active device by controlling the current in another active device of a circuit, keeping the output current constant regardless of the load. A current mirror has a high output impedance, i.e. Rₒᵤₜ is large and Cₒᵤₜ is small. Although the output impedance of the current mirror is very high, it does decrease with frequency. The inventors of the present invention have realised the advantage of implementing a current mirror as the differential output stage of an input buffer.

The current mirror circuit used in the present invention is preferably of a cascode structure. However, although a current mirror is the preferred implementation of the present invention it is realized that other loads than a current mirror are possible. For example, instead of a current mirror a folded cascade or resistive load or any other suitable load known to a person skilled in the art could be utilized.

Hence, the input buffer circuit 1 further comprises such current mirrors as loads for the differential stages 2 and 3. A first current mirror 10 includes transistors T₅ and T₆ having their drains coupled to a supply terminal V_{DD} and their gates coupled to each other. The gate of transistor T₅ is also connected to its source. The source of transistor T₅ is coupled to an output OUT_{P}.

A second current mirror 20 is identical to the first current mirror 10, and comprises transistors T₇ and T₈ having their drains coupled to the supply terminal V_{DD} and their gates coupled to each other. The gate of transistor T₇ is also connected to its source. The source of transistor T₈ is coupled to an output OUT_{N}.

The first current mirror 10 is connected to transistors of the first differential stage 2, and the second current mirror 20 is connected to transistors of the second differential stage 3. More specifically, the drains of the transistors of the first and second differential stages 2, 3 are connected to the sources of a corresponding transistor of the current mirrors 10, 20.

In the current mirrors, the currents from the differential stages are mirrored. The second differential stage thus produces a differential mode output signal at OUT_{N} and OUT_{P}, respectively.

The output signal is the differential drain currents of the transistors T₆ and T₈ and provides a differential output voltage. The differential stages 2, 3 and their current mirrors 10, 20 are thus connected so as to provide reverse signs of the output signal.

The input signal is connected to the bias circuit 4, the reference voltage of which is denoted V_{ref}. If the DC level of the input signal decreases then so does V_{ref}, and if the DC level of the input signal increases then so does V_{ref}. Stated differently, the reference voltage V_{ref} tracks the DC level of the input signal. In an embodiment of the invention, the DC level of both inputs is set by a reference current source, which provides the voltage V_{ref}.

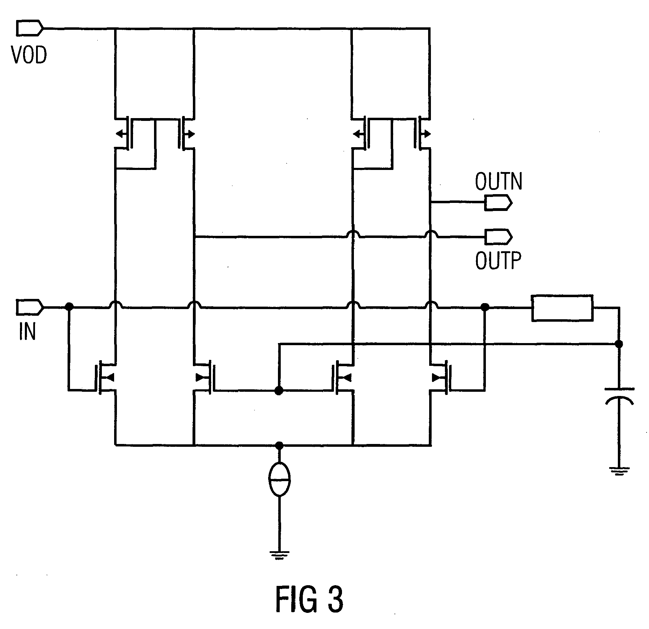

Figure 3 illustrates a second embodiment of the invention, similar to the previous embodiment. In this embodiment, an exemplary biasing circuit is shown, whereby coupling capacitances are avoided entirely. A low-pass filtering is performed and a low-pass filter is thus included. For example, an RC circuit (resistor-capacitor filter) may be utilized in order to low-pass filter the input signal.

The present invention thus provides a single-ended input to a differential output by means of two differential stages with high gain and reversed signs combined to one amplifier stage. Each differential stage comprises, in a preferred embodiment, two nmos-transistors having two pmos-transistors as load. That is, MOSFETs (metal oxide semiconductor field-effect transistor) composed of a channel of n-type or p-type semiconductor material. It is realized that other active devices such as bipolar transistors or MESFETs (Metal-Semiconductor Field Effect Transistor) may be used in alternative embodiments.

The input buffer of the present invention is preferably a CMOS (Complementary Metal-oxide semiconductor) input buffer, since CMOS devices use little power and do not produce as much heat as other forms of logic. CMOS also allows a high density of logic functions on a chip, which obviously is important in designing electrical circuits such as system-on-chip devices. However, other techniques than CMOS are conceivable.

In summary, the present invention provides an improved input device suitable for use in an electrical circuit such as a system-on-chip device. The differential output signal is less DC sensitive, i.e. provides a high common mode rejection ratio, and can after further amplification be transformed to a power supply rail-to-rail signal usually used as a clock on chip. The inventive input device is thus not sensitive to DC variations of an input signal. Further, by means of the invention the problems related to start up and power down of the device, as present in prior art solutions, are overcome. That is, the output signal reproduced by the input buffer match the input signal shape almost immediately.

In the preceding detailed description, the invention is described with reference to specific exemplary embodiments thereof. Various modifications and changes may be made thereto without departing from the scope of the invention as set forth in the claims. The specification and drawing are, accordingly, to be regarded in an illustrative rather than a restrictive sense.

## Claims

1. An input buffer amplifier (1) for an electrical circuit such as a system on chip device, the input buffer amplifier (1) comprising a single ended input terminal (In) and differential output terminals (OUTₚ, OUT_{N}), **characterised in that** said input terminal (In) is connected to a first differential stage (2) comprising two transistors (T₁, T₂) and to a second differential stage (3) comprising two transistors (T₃, T₄) , wherein the first and second differential stages (2, 3) are further connected to a respective load being connected so as to provide a differential output at the output terminals (OUTₚ, OUT_{N}).

2. An input buffer amplifier (1) as claimed in claim 1, wherein said loads connected to the first and second differential stages (2, 3) comprise a first and second current mirror (10, 20) being connected so as to provide a differential output at the output terminals (OUTₚ, OUT_{N}).

3. The input buffer amplifier (1) as claimed in claim 2, wherein in the first differential stage (2) the gate of the transistor (T₁) is connected to the input terminal (In), the sources of the transistors (T₁, T₂) are connected to a current source (5) and the drains of transistors (T₁, T₂) are connected to the sources of transistors (T₅, T₆) of the first current mirror (10) .

4. The input buffer amplifier (1) as claimed in claim 2 or 3, wherein in the second differential stage (3) the gate of the transistor (T₄) is connected to the input terminal (In), the sources of the transistors (T₃, T₄) are connected to a current source (5) and the drains of transistors (T₃, T₄) are connected to the sources of transistors (T₇, T₈) of the second current mirror (20).

5. The input buffer amplifier (1) as claimed in any of the preceding claims, wherein the gates of transistors (T₂, T₃) of the first and second differential stages (2, 3) are interconnected.

6. The input buffer amplifier (1) as claimed in any of claims 2-5, wherein the sources of a respective transistor (T₆, T₈) of said first and second current mirrors (10, 20) are connected to said output terminals (OUTₚ, OUT_{N}).

7. The input buffer amplifier (1) as claimed in any of the preceding claims, wherein the transistors (T₁, T₂, T₃, T₄) of said differential stages (2, 3) comprises nmos transistors.

8. The input buffer amplifier (1) as claimed in any of claims 2-7, wherein said current mirrors (10, 20) comprise pmos transistors.

9. An input buffer amplifier (1) as claimed in claim 1, wherein said loads connected to the first and second differential stages (2, 3) comprise a first and second folded cascade or resistive load being connected so as to provide a differential output at the output terminals (OUTₚ, OUT_{N}).

10. An electrical circuit comprising a number of clock inputs **characterised in that** it comprises, at one or more of said clock inputs, an input buffer amplifier (1) as claimed in any of the preceding claims.

11. The electrical circuit as claimed in claim 10, wherein said electrical circuit is a system on a chip.
